# EUROPÄISCHE PATENTSCHRIFT

(11) **EP 2 129 740 B1**
(45) Veröffentlichungstag und Bekanntmachung des Hinweises auf die Patenterteilung: **29.02.2012**
(21) Anmeldenummer: 08716259.0
(22) Anmeldetag: 05.03.2008
(51) Int. Cl.: C09K 11/59

(54) **VERFAHREN ZUR HERSTELLUNG VON LEUCHTSTOFFEN BASIEREND AUF ORTHOSILIKATEN FÜR PCLEDS**
METHOD FOR PRODUCING ILLUMINANTS BASED ON ORTHOSILICATES FOR PCLEDS
PROCÉDÉ DE PRODUCTION DE SUBSTANCES LUMINESCENTES À BASE D'ORTHOSILICATES POUR DIODES ÉLECTROLUMINESCENTES À CONVERTISSEUR PHOSPHORE

(30) Priorität: 04.04.2007 DE 102007016228
(43) Veröffentlichungstag der Anmeldung: 09.12.2009
(73) Patentinhaber: Merck Patent GmbH, 64293 Darmstadt (DE)
(72) Erfinder: WINKLER, Holger, 64291 Darmstadt (DE); VOSGROENE, Tim, 64372 Ober-Ramstadt (DE); TEWS, Walter, 17489 Greifswald (DE); ROTH, Gundula, 17498 Levenhagen (DE); TEWS, Stefan, 17489 Greifswald (DE)
(86) Internationale Anmeldenummer: PCT/EP2008/001742
(87) Internationale Veröffentlichungsnummer: WO 2008/122331

(56) Entgegenhaltungen:
- EP-A- 1 553 156
- WO-A-2006/061747
- US-A1- 2004 227 465
- US-A1- 2006 028 122
- US-A1- 2007 029 526
- YE ZHOU LI ET AL: "Precipitation synthesis of Sr2MgSi2O7:Eu<2+> phosphor and its luminescent properties under vacuum ultraviolet excitation" ELECTROCHEMICAL AND SOLID-STATE LETTERS ELECTROCHEM. SOC USA, Bd. 9, Nr. 10, Oktober 2006 (2006-10), Seiten J37-J39, XP002484891 ISSN: 1099-0062
- KANG H S ET AL: "Eu-doped barium strontium silicate phosphor particles prepared from spray solution containing NH4Cl flux by spray pyrolysis" 25. Juli 2005 (2005-07-25), MATERIALS SCIENCE AND ENGINEERING B, ELSEVIER SEQUOIA, LAUSANNE, CH, PAGE(S) 81 - 85 , XP004940745 ISSN: 0921-5107 2. Experimental
- NISHISU ET AL: "Preparation of Eu-doped alkaline-earth silicate phosphor particles by using liquid-phase synthesis method" JOURNAL OF ALLOYS AND COMPOUNDS, ELSEVIER SEQUOIA, LAUSANNE, CH, Bd. 408-412, 9. Februar 2006 (2006-02-09), Seiten 898-902, XP005264258 ISSN: 0925-8388

## Beschreibung

Die Erfindung betrifft ein nasschemisches Verfahren zur Herstellung von Leuchtstoffen, die aus mit Europium (II)-dotierten Orthosilikaten, vorzugsweise Erdalkaliorthosilikaten, bestehen sowie deren Verwendung als LED-Konversionsleuchtstoff für weiße LEDs oder sogenannte Color-on-demand-Anwendungen.

Unter dem Color-on-demand Konzept versteht man die Realisierung von Licht eines bestimmten Farbortes mit einer pcLED unter Einsatz eines oder mehrer Leuchtstoffe. Dieses Konzept wird z.B. verwendet, um bestimmte Corporate Designs z:B. für beleuchtete Firmenlogos, Marken etc. zu erzeugen.

In letzter Zeit wurden Leuchtstoffe, die blaugrünes Licht, gelbgrünes bis oranges Licht beruhend auf Anregung in der UV-Lichtregion oder blauen Lichtregion des optischen Spektrums ausstrahlen, immer wichtiger. Dies liegt daran, weil die Leuchtstoffe für ein weißes Licht emittierendes Gerät verwendet werden können. Speziell Cer dotierte Granat-Leuchtstoffe (YAG:Ce) werden in verschiedener Weise verwendet (siehe z.B. EP 862794, WO 98/12757). Diese weisen allerdings den Nachteil auf, dass sie nur bei einem Emissionsmaximum kleiner als 560 nm eine genügend hohe Effizienz besitzen. Aus diesem Grund können mit den reinen YAG:Ce-Leuchtstoffen in Kombination mit blauen Dioden (450-490 nm) nur kaltweiße Lichtfarben mit Farbtemperaturen zwischen 6000 und 8000 K und mit vergleichsweise niedriger Farbwiedergabe (typische Werte für den Farbwiedergabeindex Ra liegen zwischen 70 und 75) realisiert werden. Daraus ergeben sich stark eingeschränkte Anwendungsmöglichkeiten. Zum einen werden bei der Anwendung von Weißlichtquellen in der Allgemeinbeleuchtung in der Regel höhere Anforderungen an die Farbwiedergabequalität der Leuchtmittel gestellt, und zum anderen werden von den Konsumenten vor allem in Europa und in Nordamerika wärmere Lichtfarben mit Farbtemperaturen zwischen 2700 und 5000 K bevorzugt.

Aus der WO 00/33389 ist weiterhin bekannt, u.a. Ba₂SiO₄: Eu²⁺ als Luminophor zur Konvertierung des Lichtes blauer LEDs zu verwenden. Das Maximum der Emission des Leuchtstoffes liegt aber bei 505 nm, so das mit einer solchen Kombination mit Sicherheit kein weißes Licht erzeugt werden kann.

Silikatleuchtstoffe wurden in den vergangenen Jahren für weiße LEDs entwickelt (siehe WO 02/11214, WO 02/054502). Ferner ist bekannt, dass diese Leuchtstoffe für Gasentladungslampen verwendet werden können (siehe K.H. Butler "Fluorescent Lamp Phosphors" Pennsylvania Univ. Press, 1980). Außerdem beschreibt T.L. Barry, J. Electrochem. Soc. 1968, 1181, dass homogene feste Mischungen von (Ca,Sr)₂SiO₄:Eu systematisch erforscht wurde. Diese Leuchtstoffe wurden nach der Festkörperdiffusions-Methode (mixing & firing-Methode) hergestellt, indem oxidische Edukte als Pulver gemischt, vermahlen und danach in einem Ofen bei Temperaturen bis zu 1500°C bis zu mehreren Tagen in einer ggf. reduzierenden Atmosphäre geglüht werden. Als Resultat entstehen Leuchtstoffpulver, die Inhomogenitäten aufweisen in Bezug auf die Morphologie, die Partikelgrößenverteilung und die Verteilung der lumineszenten Aktivatorionen in dem Volumen der Matrix. Des weiteren sind die Morphologie, die Partikelgrößenverteilungen und weitere Eigenschaften dieser nach dem traditionellen Verfahren hergestellten Leuchtstoffe nur schlecht einstellbar und schwer reproduzierbar. Daher besitzen diese Partikel mehrere Nachteile, wie insbesondere eine inhomogene Beschichtung der LED Chips mit diesen Leuchtstoffen mit nicht optimaler und inhomogener Morphologie sowie Partikelgrößenverteilung, die zu hohen Verlustprozessen durch Streuung führen. Weitere Verluste entstehen in der Produktion dieser LEDs dadurch, dass die Leuchtstoffbeschichtung der LED Chips nicht nur inhomogen, sondern auch von LED zu LED nicht reproduzierbar ist. Dies führt dazu, dass es zu Variationen der Farborte des emittierten Lichtes der pcLEDs auch innerhalb einer Charge kommt.

Die LED-Silikatleuchtstoffe werden einzeln oder in Mischung für eine blaue oder UV LED Matrize verwendet, um einen höheren CRI als die YAG;Ce Serie zu erhalten. In der Praxis zeigen die herkömmlichen Silikatleuchtstoffe jedoch keine höhere Effizienz und Beleuchtungsstärke als die YAG:Ce Leuchtstoffe. Daneben wird berichtet (siehe T.L. Barry, J. Electrochem. Soc. 1968, 1181), dass einige Leuchtstoffe mit hoher Bariumkonzentration während der Verwendung ein Problem mit der Hydrolyseempfindlichkeit besitzen. Diese Mängel führen zu einer verminderten Effizienz der Silikatleuchtstoffe.

Aus DE 10 2005051063 A1 ist ein silikatbasierter Leuchtstoff mit verbesserter Emissionseffizienz bekannt, der nasschemisch (Nassmahl-und Nasssiebverfahren) unter Verwendung eines nichtwässrigen, organischen Lösungsmittel wie z.B. Ethanol hergestellt wurde, um das meiste Wasser zu entfernen, dass in einem Reinigungsverfahren übrig geblieben ist.

Aus Ye Zhou Li et. al., "Precipitation synthesis of Sr₂MgSi₂O₇ : Eu²⁺ Phosphor and its luminescent properties under vacuum ultraviolet excitation", Electrochemical and Solid-State Letters, 9 (10) J 37 - J 39 (2006), ist ein nasschemisches Verfahren zur Herstellung von blau emittierenden Sr₂MgSi₂O₇ : Eu²⁺ Leuchtstoffen bekannt, bei dem als Ausgangsstoffe für die Synthese Sr(NO₃)₂, Mg(NO₃)₂ · 6H₂O, TEOS und Eu₂O₃ eingesetzt werden.

In US 2007/0029526 A1 ist die Herstellung fluoridhaltiger Erdalkaliorthosilikat-Leuchtstoffe beschrieben, wobei in einem nasschemischen Co-Fällungsverfahren unter anderem Sr(NO₃)₂ und Eu₂O₃ als Ausgangsstoffe verwendet werden.

Auch aus US 2006/0028122 A1 ist ein Verfahren zur Herstellung fluoridhaltiger Erdalkaliorthosilikat-Leuchtstoffe bekannt, bei welchem Erdalkalinitrate und Europiumoxid als Ausgangsstoffe für ein Sol-Gel-Verfahren dienen.

Aus EP 1553156 A2 ist ein Verfahren zur Herstellung Aluminat-basierender Leuchtstoffe bekannt, bei dem der Aluminat-Leuchtstoffprecursor mittels einer nasschemischen Fällung mit einer organischen Säure, beispielsweise Oxalsäure, aus den Aluminium- und Erdalkaliverbindungen hergestellt werden kann.

In US 2004/0227465 A1 ist ein Verfahren zur Herstellung von Leuchtstoffen gemäß der allgemeinen Formel SrₓBa_{y}Ca_{z}SiO₄:Eu beschrieben, bei dem vorzugsweise Erdalkalicarbonate und SiO₂ miteinander gemischt und bei Temperaturen oberhalb 1000°C kalziniert werden.

Aus Hee Sang Kang et. al., "Eu-doped barium strontium silicate phosphor particles prepared from spray solution containing NH4Cl flux by spray pyrolysis", Materials Science and Engineering, B 121 (2005) 81 - 85, ist ein Sprühpyrolyseverfahren zur Herstellung von Leuchtstoffen bekannt, bei welchem Erdalkalinitrate, Europiumoxid and TEOS als Ausgangsmaterialien verwendet werden.

Ein weiteres nasschemisches Verfahren zur Herstellung von Erdalkaliorthosilikat-Leuchtstoffen ist aus Y. Nishisu et. al., "Preparation of Eu-doped-alkaline-earth silicate phosphor particles by using liquid-phase synthesis method", Journal of Alloys and Compounds 408 - 412 (2006), 898 - 902, bekannt. Die Leuchtstoffprecursoren werden mittels eines sauer oder basisch katalysierten Sol-Gel-Verfahrens hergestellt.

Aufgabe der vorliegenden Erfindung ist es daher Erdalkaliorthosilikat-Leuchtstoffe für weiße LEDs oder für Color-on-demand-Anwendungen zur Verfügung zu stellen, die einen oder mehrere der oben genannten Nachteile nicht aufweisen und warm weißes Licht erzeugen.

Diese Aufgabe wird überraschenderweise dadurch gelöst, dass man die Erdalikaliorthosilikat-Leuchtstoffe nasschemisch herstellt.

Gegenstand der vorliegenden Erfindung ist somit ein Verfahren zur Herstellung von Leuchtstoffen der Formel I

Ba_{w}SrₓCa_{y}Eu_{z}SiO₄ (I)

wobei
w + x + y + z = 2 und
0,005 < z < 0,5 gilt,
dadurch gekennzeichnet, dass
a) mindestens zwei Erdalkali halogenide sowie ein Europium-haltiger Dotierstoff in Form von Chloriden oder deren Gemische in Wasser gelöst oder suspendiert werden und
b) eine Silicium-haltige Verbindung zugesetzt wird und
c) zu diesem Gemisch ein anorganisches oder organisches Fällungsreagenz zugegeben wird und
d) der entstehende Leuchtstoffprecursor durch thermische Nachbehandlung zum fertigen Leuchtstoff umgewandelt wird.

Dabei können w, x, y oder z Werte zwischen 0 und 2 annehmen.

Als Erdalkalimetall-Edukte werden Barium-, Strontium- und/oder Calciumhalogenide im gewünschten stöchiometrischen Verhältnis eingesetzt. Vorzugsweise werden die entsprechenden Chloride eingesetzt.

Als Silicium-haltige Verbindung kommen beim ersten Verfahren generell anorganische oder organische Silicium-Verbindungen in Betracht. Als anorganische Silicium-Verbindung wird vorzugsweise feindisperses SiO₂-Sol oder -Gel verwendet.

Als organische Silicium-Verbindungen werden bevorzugt vorkondensierte Kieselsäureester der Formel Si(OR)₄ mit R = Methyl, Ethyl, Propyl, Butyl wie z.B. TES-28^{®} oder TES-40^{®} (Fa. Wacker). Besonders bevorzugt wird Si(OEt)₄ eingesetzt.

Als Dotierstoff wird Europiumchlorid eingesetzt. Bevorzugt ist es ferner, wenn die Dotierkonzentration des Europiums zwischen 0,5 und 50 Mol% liegt. Besonders bevorzugt liegt sie zwischen 2,0 und 20 Mol% Bei einer Europium-Konzentration zwischen 10 und 15 Mol% kommt es generell zu einer verstärkten Absorption und dadurch zu einer erhöhten Lichtausbeute bzw. einer größeren Helligkeit des Leuchtstoffes. Eine höhere Europium-Konzentration würde die Quantenausbeute reduzieren und damit wiederum zu einer verringerten Lichtausbeute führen.

Das nasschemische Verfahren führt zum Leuchtstoffprecursor (Leuchtstoffvorstufe), der durch eine thermische Nachbehandlung (Glühprozess) in den fertigen Leuchtstoff umgewandelt wird.

Für die nasschemische Vorbehandlung einer wässrigen Vorstufe der Leuchtstoffe ("Leuchtstoffprecursoren") bestehend aus einem Gemisch von einem Barium-, Strontium- und Europiumhalogenid und einer Silicium-haltigen Verbindung ist folgende Methode bevorzugt:
- Hydrogencarbonat-Fällung mit einer anorganischen oder organischen Siliciumverbindung wie SiO₂ oder Si(OEt)₄

Bei der sog. Hydrogencarbonat-Fällung werden zunächst die Erdalkali-Edukte als Erdalkalihalogenide mit einem Europium-haltigen Dotierstoff in Wasser gelöst und anschließend eine anorganische oder organische Silicium-haltige Verbindung zugegeben. Es wird mit einer Hydrogencarbonat-Lösung gefällt, wodurch sich der Leuchtstoffprecursor langsam bildet.

Die thermische Nachbehandlung des Leuchtstoffprecursors zum fertigen Leuchtstoff erfolgt in einem thermischen Reaktor bzw. Hochtemperaturofen durch mehrstündiges Glühen einer definierten Menge Precursor bei Temperaturen zwischen 1000°C und 1400 °C in Korundtiegeln. Der Leuchtstoffrohkuchen wird, zerkleinert, gewaschen und gesiebt. Dabei kann der Hochtemperaturofen ein Drehrohrofen, Kammerofen, Rohrofen oder ein Wirbelschichtreaktor sein, wobei bevorzugt ein Kammerofen verwendet wird.

Bei der oben genannten thermischen Nachbehandlung ist es bevorzugt, wenn die Glühung zumindest teilweise unter reduzierenden Bedingungen (z.B. mit Kohlenmonoxid, Formiergas oder Wasserstoff oder zumindest Vakuum oder Sauerstoffmangel-Atmosphäre) durchgeführt wird.

Die Partikelgröße der erfindungsgemäßen Leuchtstoffe beträgt zwischen 50 nm und 50 µm, vorzugsweise zwischen 1 µm und 25 µm.

Weiterhin kann es bevorzugt sein, wenn vor oder während der thermischen Nachbehandlung ein anorganisches Salz als Flussmittel zur Schmelzpunkterniedrigung zugegeben wird. Als anorganisches Salz können Chloride, vorzugsweise Ammoniumchlorid, oder Nitrate oder Chlorate in einer Menge von 0.5 bis 80 %, vorzugsweise 1 bis 5 %, bezogen auf die eingesetzte Edukt-Menge, verwendet werden.

In einer weiteren bevorzugten Ausführungsform besitzt der Leuchtstoff auf der, einem LED Chip entgegengesetzten Seite eine strukturierte (z.B. pyramidale) Oberfläche (siehe DE 102006054330.0, Merck, die voll umfänglich in den Kontext der vorliegenden Anmeldung durch Bezugnahme eingefügt wird). Somit kann möglichst viel Licht aus dem Leuchtstoff ausgekoppelt werden.

Die strukturierte Oberfläche auf dem Leuchtstoff wird durch nachträgliches Beschichten mit einem geeigneten Material, welches bereits strukturiert ist, oder in einem nachfolgenden Schritt durch (photo-) lithografische Verfahren, Ätzverfahren oder durch Schreibverfahren mit Energie- oder Materiestrahlen oder Einwirkung von mechanischen Kräften hergestellt.

In einer weiteren bevorzugten Ausführungsform besitzen die erfindungsgemäßen Leuchtstoffe auf der, einem LED Chip entgegengesetzten Seite eine raue Oberfläche, die Nanopartikel aus SiO₂, TiO₂, Al₂O₃, ZnO₂, ZrO₂ und/oder Y₂O₃ oder Kombinationen aus diesen Materialien oder aus Partikeln mit der Leuchtstoffzusammensetzung trägt. Dabei hat eine raue Oberfläche eine Rauhigkeit von bis zu einigen 100 nm. Die beschichtete Oberfläche hat den Vorteil, dass Totalreflexion verringert oder verhindert werden kann und das Licht besser aus dem erfindungsgemäßen Leuchtstoff ausgekoppelt werden kann (siehe DE 102006054330.0 (Merck), die voll umfänglich in den Kontext der vorliegenden Anmeldung durch Bezugnahme eingefügt wird.)

Weiterhin bevorzugt ist es, wenn die erfindungsgemäßen Leuchtstoffe auf der dem Chip abgewandten Oberfläche eine Brechzahl angepasste Schicht besitzen, welche die Auskopplung der Primärstrahlung und oder der vom Leuchtstoffkörper emittierten Strahlung erleichtert.

In einer weiteren bevorzugten Ausführungsform besitzen die Leuchtstoffe eine geschlossene Oberflächenbeschichtung, die aus SiO₂, TiO₂, Al₂O₃, ZnO, ZrO₂ und/oder Y₂O₃ oder Mischoxiden daraus besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächenbeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schliesslich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn die Leuchtstoffe eine poröse Oberflächenbeschichtung besitzen, die aus aus SiO₂, TiO₂, Al₂O₃, ZnO, ZrO₂ und/oder Y₂O₃ oder Mischoxiden daraus oder aus der Leuchtstoff-zusammensetzung besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Ausführungsform besitzen die Leuchtstoffe eine Oberfläche, die funktionelle Gruppen trägt, welche eine chemische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Da die auf dem LED Chip aufgebrachte erfindungsgemäße Leuchtstoffschicht vorzugsweise aus einem Gemisch von Silikon und homogenen Leuchtstoffpartikeln besteht, und das Silikon eine Oberflächenspannung aufweist, ist diese Leuchtstoffschicht auf mikroskopischer Ebene nicht einheitlich bzw. ist die Dicke der Schicht nicht durchweg konstant.

Mit dem Verfahren gemäβ der vorliegenden Erfindung wird ein Leuchtstoff der Formel I

Ba_{w}SrₓCa_{y}SiO₄: zEu²⁺ (I)

wobei
w + x +y + z = 2 und
0,005 < z < 0,5 gilt, hergestellt.

Vorzugsweise besitzt dieser Leuchtstoff eine strukturierte Oberfläche oder eine raue Oberfläche, die Nanopartikel aus SiO₂, TiO₂, Al₂O₃, ZnO, ZrO₂ und/oder Y₂O₃ oder Mischoxide daraus oder aus Partikeln mit der Leucttoffzusammensetzung trägt.

Weiterhin bevorzugt ist es, wenn dieser Leuchtstoff der Formel I eine geschlossene oder aber poröse Oberflächenbeschichtung besitzt, die aus SiO₂, TiO₂, Al₂O₃, ZnO, ZrO₂ und/oder Y₂O₃ oder Mischoxiden daraus besteht.

Ferner kann es bevorzugt sein, wenn die Oberfläche des Leuchtstoffes funktionelle Gruppen trägt, welche eine chemische Anbindung an die Umgebung, vorzugsweise aus Epoxy- oder Silikon harz, ermöglicht.

Mit Hilfe der o.g. Verfahren können beliebige äußere Formen der Leuchtstoffpartikel hergestellt werden, wie sphärische Partikel, Plättchen und strukturierte Materialien und Keramiken.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und DE 102006054331.9 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss dieses aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht.

Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1 : 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.

Die dem LED Chip zugewandte Oberfläche des plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den Leuchtstoffkörper eingekoppelt werden kann.

Hierfür eignen sich beispielsweise brechzahlangepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der Leuchtstoffe in Form von keramischen Körpern erfolgt analog nach dem in der DE 102006037730 (Merck) beschrieben Verfahren, die voll umfänglich in den Kontext der vorliegenden Anmeldung durch Bezugnahme eingefügt wird. Dabei wird der Leuchtstoff durch Mischen der entsprechenden Edukte und Dotierstoffe nasschemisch hergestellt, anschließend isostatisch verpresst und in Form eines homogenen dünnen und nicht porösen Plättchens direkt auf die Oberfläche des Chips aufgebracht. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm grosstechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneider der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.

Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.

Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Die Anregbarkeit der erfindungsgemäß hergestellten Leuchtstoffe erstreckt sich zudem über einen weiten Bereich, der von etwa 120 nm bis 530 nm, bevorzugt 254 nm bis zu etwa 480 nm reicht. Damit sind diese Leuchtstoffe nicht nur zur Anregung durch UV oder blau emittierende primären Lichtquellen wie LEDs oder konventionelle Entladungslampen (z.B. auf Hg-Basis) geeignet, sondern auch für Lichtquellen wie solche, welche die blaue In³⁺ -Linie bei 451 nm ausnutzen.

Des Weiteren kann eine Beleuchtungseinheit mit mindestens einer primären Lichtquelle, deren Emissionsmaximum bzw. -maxima im Bereich von 120 nm bis 530 nm liegt, und bevorzugt von 254 nm bis zu etwa 480 nm reicht, wobei die primäre Strahlung teilweise oder vollständig durch die erfindungsgemäß hergestellten Leuchtstoffe in längerwellige Strahlung konvertiert wird, erhalten werden.

Der Begriff "Beleuchtungseinheit" umfasst folgende Bau-oder Bestandteile:
- mindestens eine primäre Lichtquelle um ultraviolettes oder blaues Licht zu emittieren,
- mindestens einen Konversionsleuchtstoff, der sich im direkten oder indirekten Kontakt mit einer primären Lichtquelle befindet,
- gegebenenfalls ein transparentes Dichtungsharz (z.B. Epoxy- oder Silikonharz) zur Kapselung der Beleuchtungseinheit,
- gegebenenfalls ein Trägerbauteil, auf welchem die primäre Lichtquelle montiert ist und welches mindestens zwei elektrische Anschlüsse zum Zuführen elektrischer Energie für die primäre Lichtquelle besitzt,
- gegebenenfalls Sekundär- optische Anordnungen wie Linsen, Spiegel, Prismen oder photonische Kristalle.

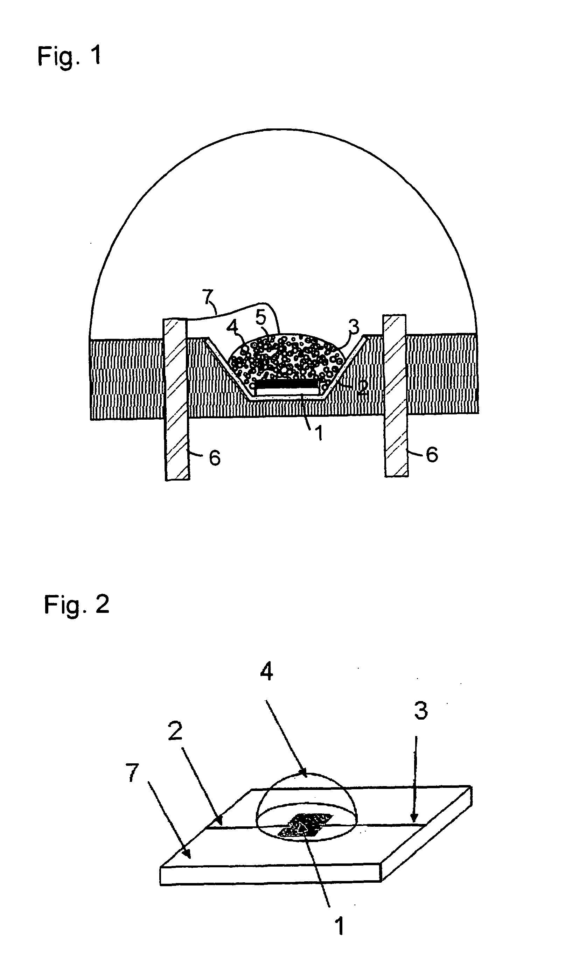

Vorzugsweise ist diese Beleuchtungseinheit weiß emittierend oder emittiert Licht mit einem bestimmten Farbort (Color-on-demand-Prinzip). Bevorzugte Ausführungsformen der Beleuchtungseinheiten sind in den Figuren 1 bis 12 beschrieben.

In einer bevorzugten Ausführungsform der Beleuchtungseinheit handelt es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.

Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der Beleuchtungseinheit handelt es sich bei der Lichtquelle um eine lumineszente auf ZnO, TCO (Transparent conducting oxide), ZnSe oder SiC basierende Anordnung oder auch um eine auf einer organischen lichtemittierende Schicht basierende Anordnung (OLED).

In einer weiteren bevorzugten Ausführungsform der Beleuchtungseinheit handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Die erfindungsgemäß hergestellten Leuchtstoffe können entweder in einem Harz dispergiert (z.B. Epoxy- oder Siliconharz), oder bei geeigneten Größenverhältnissen direkt auf der primären Lichtquelle angeordnet werden oder aber von dieser, je nach Anwendung, entfernt angeordnet sein (letztere Anordnung schliesst auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol 44, No. 21 (2005). L649-L651.

In einer weiteren Ausführungsform ist es bevorzugt, wenn die optische Ankopplung der Beleuchtungseinheit zwischen dem Leuchtstoff und der primären Lichtquelle durch eine lichtleitende Anordnung realisiert wird. Dadurch ist es möglich, dass an einem zentralen Ort die primäre Lichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem oder mehreren Lichtleitern, die an die primäre Lichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Weiterhin ist es bevorzugt, wenn die primäre Lichtquelle, welche Licht im Vakuum-UV (< 200nm) und/oder UV emittiert, in Kombination mit dem erfindungsgemäßen Leuchtstoff eine Emissionsbande mit einer Halbwertsbreite von mindestens 10 nm aufweist.

Die erfindungsgemäß hergestellten Leuchtstoffe werden zur teilweisen oder vollständigen Konversion der blauen oder im nahen UV-liegenden Emission einer Lumineszenzdiode verwendet.

Weiterhin bevorzugt ist die Verwendung der Leuchtstoffe zur Konversion der blauen oder im nahen UV-liegenden Emission in sichtbare weiße Strahlung. Weiterhin ist die Verwendung der Leuchtstoffe zur Konversion der Primärstrahlung in einen bestimmten Farbort nach dem "Color on demand"-Konzept bevorzugt.

Die erfindungsgemäß hergestellten Leuchtstoffe werden auch in Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelb-grünen Bereich emittieren, verwendet. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele 4 und 5 sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Beispiel 1: Herstellung des Leuchtstoffes Ba_{0.345}Sr_{1.6}Eu_{0.055}SiO₄ durch Umsetzung der Erdalakalihydroxide mit Tetraethylorthosilikat

55,18g Ba(OH)₂x 8H₂O (Qualität reinst, Fa. Merck KGaA), 212,496g Sr(OH)₂x 8H₂O (Qualität reinst, Fa. Merck KGaA) und 10,08 g EuCl₃x 6H₂O (Qualität zur Analyse ACS, Fa. Treibacher Industrie AG) werden in einem 500 ml-Dreihalskolben unter Zugabe von 20 ml VE-Wasser bei 120°C im Ölbad gerührt (KPG-Rührer). Es entsteht eine breiige Konsistenz. Nach weiteren 60 min Rühren ist die Mischung dünnflüssig.

104,164 g Tetraethylorthosilikat (Qualität zur Analyse, Fa. Merck KGaA) werden unter Rühren rasch zugegeben die Suspension dickt daraufhin ein. Weitere 20ml VE-Wasser werden zugegeben, daraufhin resultiert wieder eine dünnflüssige Mischung.

Nach 60 min wird die Heizung abgestellt und das Gemisch unter Rühren auf ca. 50°C abgekühlt.

250ml Aceton werden zugegeben, die Suspension langsam auf Raumtemp. abgekühlt und über Nacht gerührt.

Der Niederschlag wird abgenutscht und mit 150ml Aceton gewaschen und anschließend im Vakuum getrocknet.

### Beispiel 2: Herstellung des Leuchtstoffes Ba_{0.345}Sr_{1.6}Eu_{0.055}SiO₄ aus der Oxalat-Fällung mit hochdispersem Siliciumdioxid

126,07g Oxalsäure-Dihydrat werden in 1,236 1 VE-Wasser gelöst. Es wird 12,016 g Siliciumdioxid zugegeben. 16,855 g Bariumchlorid Dihydrat (Qualität zur Analyse, Fa. Merck KGaA), 85,288 g Strontiumchlorid Hexahydrat (Qualität zur Analyse, Fa. Merck KGaA) sowie 4,030 g Europiumchlorid Hexahydrat (Qualität zur Analyse ACS, Fa. Treibacher Industrie AG) werden in 200 ml VE-Wasser gelöst und in 30min unter Rühren in die Oxalsäure-Dihydrat/Siliciumdioxid Lösung getropft. Während des Zutropfens fällt die Temperatur auf 15°C.

Dann wird das Gemisch 2h am Rückfluß gekocht. Es wird über Nacht zum Abkühlen stehen gelassen und am nächsten Tag abgesaugt.

Das Produkt wird über 24 Stunden bei 75°C unter leichtem Vakuum getrocknet.

### Beispiel 3: Herstellung des Leuchtstoffes Ba_{0.345}Sr_{1.6}Eu_{0.055}SiO₄ aus Oxalat-Fällung mit Tetraethylorthosilikat

126,07 g Oxalsäure-Dihydrat werden in 1,236 I VE-Wasser gelöst. Es wird 41,66 g Tetraethylorthosilikat zugegeben. 16,855 g Bariumchlorid Dihydrat (Qualität zur Analyse ACS, ISO Reag. Ph Eur, Fa. Merck KGaA), 85,288 g Strontiumchlorid Hexahydrat (Qualität zur Analyse, Fa. Merck KGaA) sowie 4,030 g Europiumchlorid Hexahydrat (Qualität zur Analyse ACS, Fa. Treibacher Industrie AG) werden in 200 ml VE-Wasser gelöst und in 30 min unter Rühren in die Oxalsäure-Dihydrat/Siliciumdioxid Lösung getropft.

Zu Beginn des Zutropfens fällt die Temperatur auf 16°C, steigt dann aber beim weiteren Zutropfen. Dann wird das Gemisch 3h am Rückfluß gekocht. Es wird auf Raumtemperatur abgekühlt und abgesaugt. Das Produkt wird über 24 Stunden bei 75°C unter leichtem Vakuum getrocknet.

### Beispiel 4: Herstellung des Leuchtstoffes Ba_{0.345}Sr_{1.6}Eu_{0.055}SiO₄ aus der Hydrogencarbonat-Fällung mit hochdispersem Siliciumdioxid

16,9g BaCl₂x 2H₂O (Qualität zur Analyse Fa. Merck KGaA), 85,3g SrCl₂x 6H₂O (Qualität zur Analyse Fa. Merck KGaA), und 4,0g EuCl₃x 6H₂O (Qualität zur Analyse ACS, Fa. Treibacher Industrie AG), werden in einem 1000 ml-Dreihalskolben in 360ml VE-Wasser gelöst. Es werden 12,0g SiO₂ zugegeben. Bei 18°C werden 79,1g Ammoniumhydrogencarbonat zugegeben -> starkes Schäumen (starke Gasentwicklung) und Endothermie bis +7°C.

Die entstandene Suspension wird auf 88°C erwärmt (100°C Badtemp.) und 2 Std. gerührt. Die entstandene Suspension wird über Nacht auf 20°C abgekühlt und die Kristalle ohne Nachwaschen abgesaugt. Die Mutterlauge ist klar und farblos (pH 9).

### Beispiel 5: Herstellung des Leuchtstoffes Ba_{0.345}Sr_{1.6}Eu_{0.055}SiO₄ aus Hydrogencarbonat-Fällung mit Tetraethylorthosilikat

16,9g BaCl₂x 2H₂O (Qualität zur Analyse Fa. Merck KGaA), 85,3g SrCl₂x 6H₂O (Qualität zur Analyse Fa. Merck KGaA) und 4,0g EuCl₃x 6H₂O (Qualität zur Analyse ACS, Fa. Treibacher Industrie AG) werden in einem 1000 ml-Dreihalskolben in 360 ml VE-Wasser gelöst. Es werden 41,7g Tetraethylorthosilikat (Qualität zur Synthese, Fa. Merck KGaA) zugegeben. Bei 17°C werden 79,1 g Ammoniumhydrogencarbonat zugegeben -> starkes Schäumen (starke Gasentwicklung) und Endothermie bis +7°C. Die entstandene Suspension wird auf 88°C erwärmt (100°C Badtemp.) und 2 Std. gerührt. Die entstehende Suspension wird über Nacht auf 20°C abgekühlt und die Kristalle salzfrei gewaschen und abgesaugt. Die Precursoren aus den Beispielen 1 und 5 werden dann in einem in reduzierender Formiergasatmosphäre stattfindenden Glühprozess bei 1200°C in die Leuchtstoffe umgesetzt. Dazu werden die Precursoren in 250 ml Korundtiegel gegeben, mit 5 wt% Ammoniumchlorid unterschichtet, festgerüttelt und anschließend für 5 Stunden geglüht. Der fertige Leuchtstoffrohkuchen wird anschließend in einer Mörsermühle gemahlen, danach gewaschen, getrocknet (T = 120°C) und gesiebt.

### Vergleichsbeispiel 6: Herstellung des Leuchtstoffes Ba_{0.345}Sr_{1.6}Eu_{0.055}SiO₄ nach herkömmlicher Festkörperreaktionsmethode

Für 1 Mol Leuchtstoff werden stöchiometrische Mengen von BaCO₃, SrCO₃, Eu₂O₃ und SiO₄ entsprechend der obigen Formelzusammensetzung zusammen mit 0,2-0,3 Mol NH₄Cl in der Kugelmühle für 5 h intensiv vermahlen.

Die homogene Ausgangsmischung wird in Korundtiegel gefüllt und bei 1200-1400°C für 3-10h unter reduzierender Atmosphäre (Formiergas N₂/H₂) zur Reaktion gebracht.

Der so erhaltene Rohleuchtstoff wird fein zermahlen, 4-5 mal mit deionisiertem Wasser gewaschen, anschließend filtriert und für mehrere Stunden bei 100°C im Trockenschrank von der Restfeuchte befreit. Der getrocknete Leuchtstoff wird entsprechend der Zielkorngröße trocken gesiebt.

### Beschreibung der Abbildungen

Im folgenden soll die Erfindung anhand mehrerer Ausführungsbeispiele näher erläutert werden. In den Fig. 1 bis 12 werden verschiedene Beleuchtungseinheiten beschrieben, die alle die erfindungsgemäß hergestellten Orthosilikatleuchtstoffe enthalten:
Fig. 1: zeigt die schematische Abbildung einer Leuchtdiode mit einer Leuchtstoff-haltigen Beschichtung. Das Bauteil umfasst eine Chip-artige Leuchtdiode (LED) 1 als Strahlungsquelle. Die Licht emittierende Diode ist in einem becherförmigen Reflektor angebracht, der von einem Justagerahmen 2 gehalten wird. Der Chip 1 ist über ein Flachkabel 7 mit einem ersten Kontakt 6 und direkt mit einem zweiten elektrischen Kontakt 6' verbunden. Auf die innere Wölbung des Reflektorbechers wurde eine Beschichtung aufgebracht, die einen erfindungsgemäß hergestellten Konversionsleuchtstoff enthält. Die Leuchtstoffe werden entweder getrennt voneinander oder als Mischung eingesetzt. (Liste der Teilenummern: 1 Leuchtdiode, 2 Reflektor, 3 Harz, 4 Konversionsleuchtstoff, 5 Diffusor, 6 Elektroden, 7 Flachkabel)
Fig_ 2: zeigt ein COB (Chip on board) Package des Typs InGaN, das als Lichtquelle (LED) für weißes Licht dient (1=Halbleiterchip; 2,3 = elektr. Anschlüsse; 4 = Konversionsleuchtstoff; 7 = Board (Platine) Der Leuchtstoff ist in einer Bindemittellinse verteilt, die gleichzeitig ein sekundäres optisches Element darstellt und die Lichtabstrahlcharakteristik als Linse beeinflusst.
Fig₋3: zeigt ein COB (Chip on board) Package des Typs InGaN, das als Lichtquelle (LED) für weißes Licht dient (1 =Halbleiterchip; 2,3 = elektr. Anschlüsse; 4 = Konversionsleuchtstoff; 7 = Board (Platine) Der Leuchtstoff befindet sich in einer dünnen Bindelmittelschicht verteilt direkt auf dem LED Chip. Ein sekundäres optisches Element bestehend aus einem transparenten Material kann darauf platziert werden.

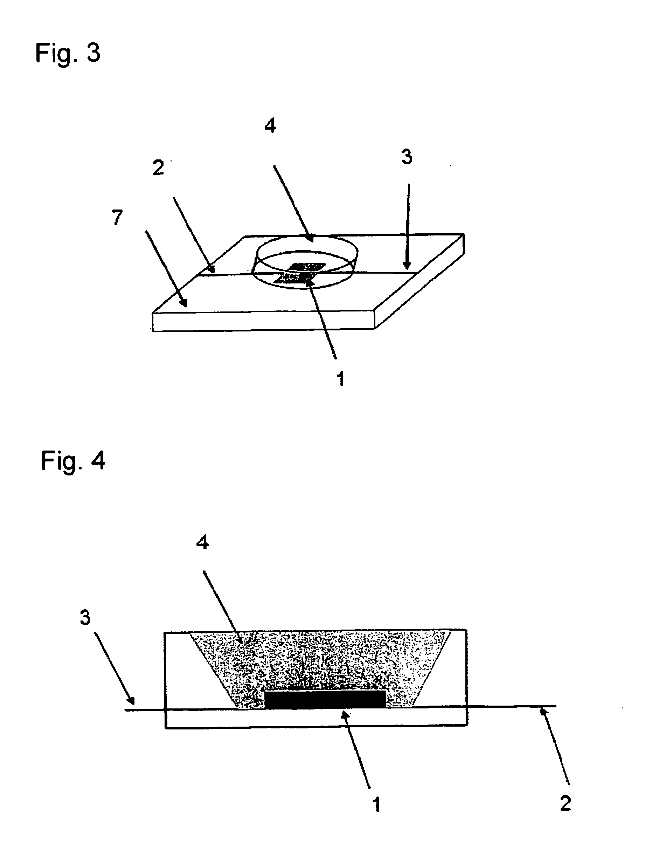

Fig.4: zeigt eine Art von Package, das als Lichtquelle (LED) für weißes Licht dient (1=Halbleiterchip; 2,3 = elektr. Anschlüsse; 4 = Konversionsleuchtstoff in Kavität mit Reflektor). Der Konversionsleuchtstoff befindet sich in einem Bindemittel dispergiert, wobei die Mischung die Kavität ausfüllt.

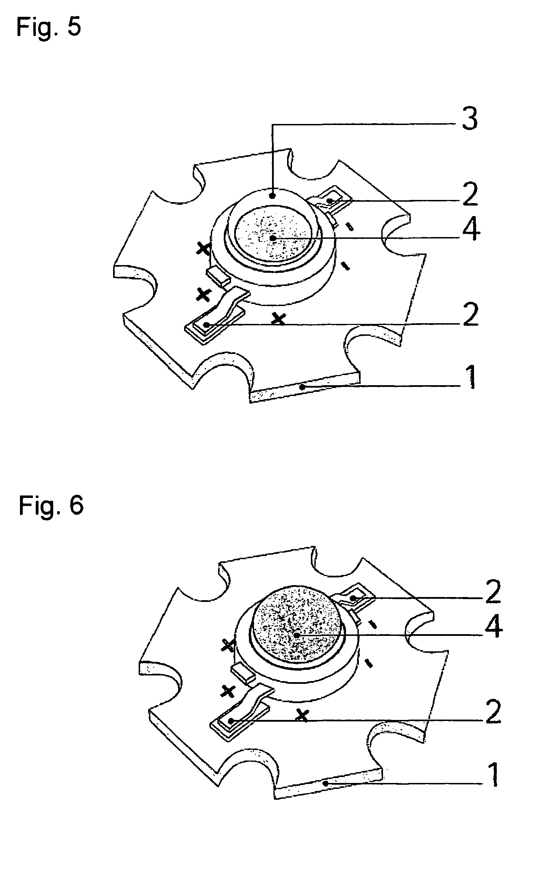

Fig.5: zeigt eine zweite Art von Package, wobei 1= Gehäuseplatte; 2 = elektr. Anschlüsse; 3 = Linse; 4= Halbleiterchip bedeutet. Dieses Design hat den Vorteil, dass es sich um ein Flipchip-Design handelt, wobei über das transparente Substrat und einem Reflekor auf dem Boden ein größerer Anteil des Lichtes aus dem Chip für Lichtzwecke verwendet werden kann. Außerdem ist die Wärmeableitung bei diesem Design begünstigt.
Fig.6: zeigt ein Package , wobei 1= Gehäuseplatte; 2 = elektr. Anschlüsse; 4= Halbleiterchip bedeutet, und der Hohlraum unterhalb der Linse komplett mit dem erfindungsgemäß hergestellten Konversionsleuchtstoff ausgefüllt ist. Dieses Package hat den Vorteil, dass eine größere Menge Konversionsleuchtstoff verwendet werden kann. Dieser kann auch als Remote Phosphor wirken.

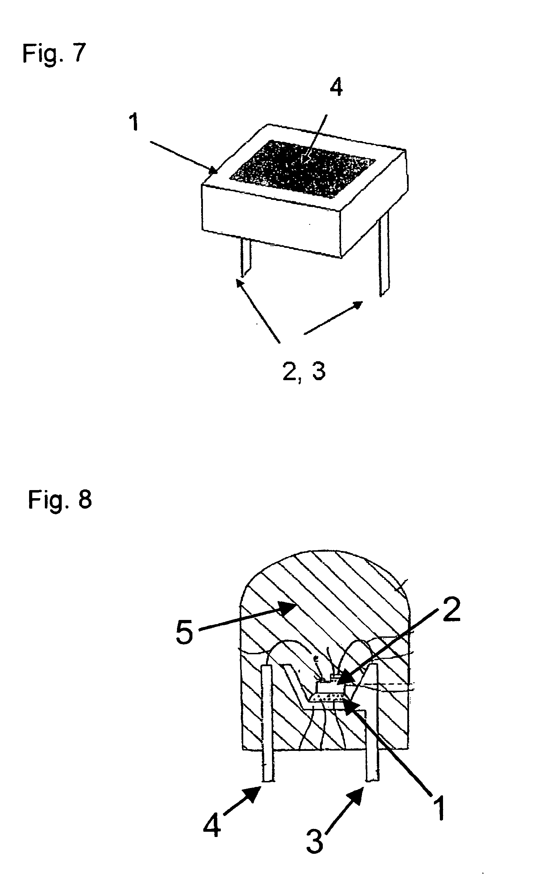

Fig. 7: zeigt ein SMD-Package (Surface mounted package) wobei 1= Gehäuse; 2, 3 = elektr. Anschlüsse, 4 = Konversionsschicht bedeutet. Der Halbleiterchip ist komplett mit dem erfindungsgemäß hergestellten Leuchtstoff bedeckt. Das SMD-Design hat den Vorteil, dass es eine kleine Bauform hat und somit in herkömmliche Leuchten passt.
Fig._8: zeigt ein T5-Package, wobei 1 = Konversionsleuchtstoff; 2 = Chip; 3,4 = elektr. Anschlüsse; 5 = Linse mit transparenten Harz bedeutet. Der Konversionsleuchtstoff befindet sich auf der Rückseite des LED-Chips, was den Vorteil hat, dass der Leuchtstoff über die metallischen Anschlüsse gekühlt wird.
Filz. 9: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff in einem Bindemittel als Top Globe aufgebracht ist. Diese Form der Leuchtstoff-/Bindemittelschicht kann als sekundäres optisches Element wirken und z. B. die Lichtausbreitung beeinflussen.

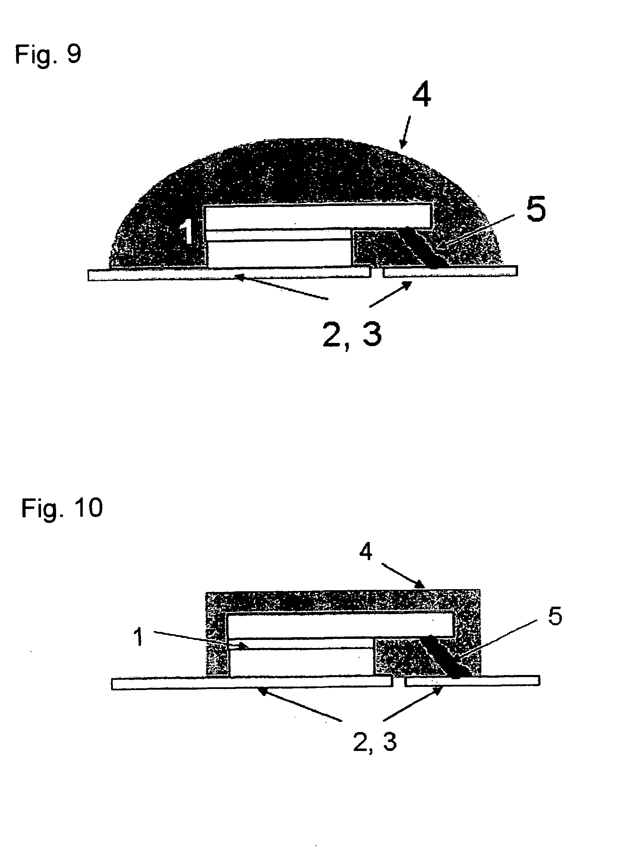

Fig. 10: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff als dünne Schicht in einem Bindemittel dispergiert aufgebracht ist. Auf diese Schicht lässt sich leicht ein weiteres, als sekundäres optisches Element wirkendes Bauteil, wie z.B eine Linse aufbringen.

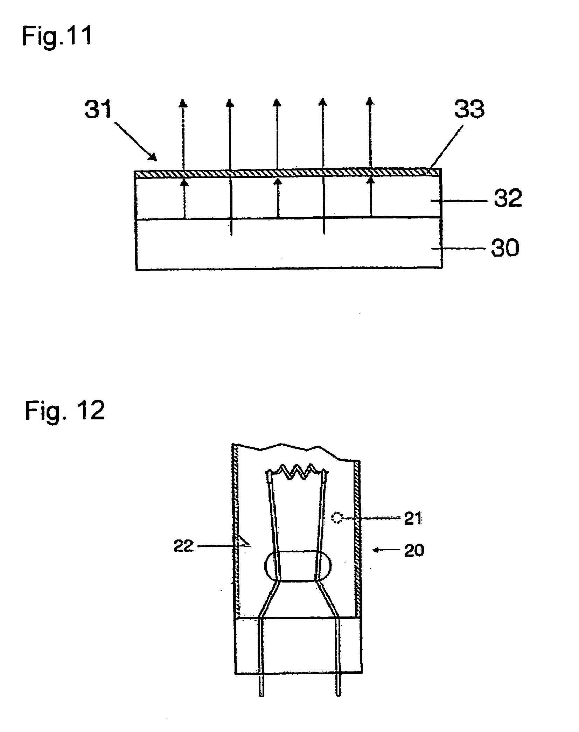

Fig. 11: zeigt ein Beispiel für eine weitere Anwendung, wie sie im Prinzip bereits aus US-B 6,700,322 bekannt ist. Dabei wird der erfindungsgemäß hergestellte Leuchtstoff zusammen mit einer OLED angewendet. Die Lichtquelle ist eine organisch lichtemittierende Diode 31, bestehend aus der eigentlichen organischen Folie 30 und einem transparenten Substrat 32. Die Folie 30 emittiert insbesondere blaues primäres Licht, erzeugt beispielsweise mittels PVK:PBD:Kumarin (**PVK**, Abk. für poly(n-vinylcarbazol); **PBD**, Abk. für 2-(4-biphenyl)-5-(4-tert.-butylphenyl)-1,3,4-oxadiazol)). Die Emission wird von einer Deckschicht, gebildet aus einer Schicht 33 des Leuchtstoffs, teilweise in gelbes, sekundär emittiertes Licht umgewandelt, so dass insgesamt durch Farbmischung des primär und sekundär emittierten Lichts eine weiße Emission realisiert wird. Die OLED besteht im wesentlichen aus mindestens einer Schicht eines lichtemittierenden Polymers oder von sog. small molecules zwischen zwei Elektroden, die aus an sich bekannten Materialien bestehen, wie bespielsweise ITO (Abk. für "indium tin oxide") als Anode und ein hochreaktives Metall, wie z.B. Ba oder Ca, als Kathode. Oft werden auch mehrere Schichten zwischen den Elektroden verwendet, die entweder als Lochtransportschicht dienen oder im Bereich der small molecules auch als Elektronentransportschichten dienen. Als emittierende Polymere kommen beispielsweise Polyfluorene oder Polyspiro-Materialien zum Einsatz.
Fig. 12: zeigt eine Niederdrucklampe 20 mit einer quecksilberfreien Gasfüllung 21 (schematisiert), die eine Indium-Füllung und ein Puffergas analog WO 2005/061659 enthält, wobei eine Schicht 22 aus den erfindungsgemäß hergestellten Leuchtstoffen angebracht ist.

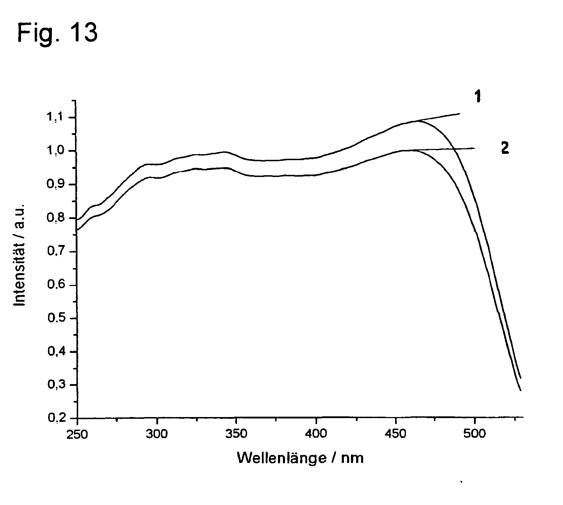

Fig.13: zeigt einen Vergleich der Anregungsspektren von: 1 = erfindungsgemäß hergestellter Leuchtstoff Ba_{0.345}Sr_{1.6}Eu_{0.055}SiO₄ hergestellt durch Hydrogencarbonat-Fällung; 2 = Leuchtstoff der gleichen Zusammensetzung wie unter 1, hergestellt nach der herkömmlichen Festkörperreaktionsmethode (siehe Vergleichsbeispiel 6).

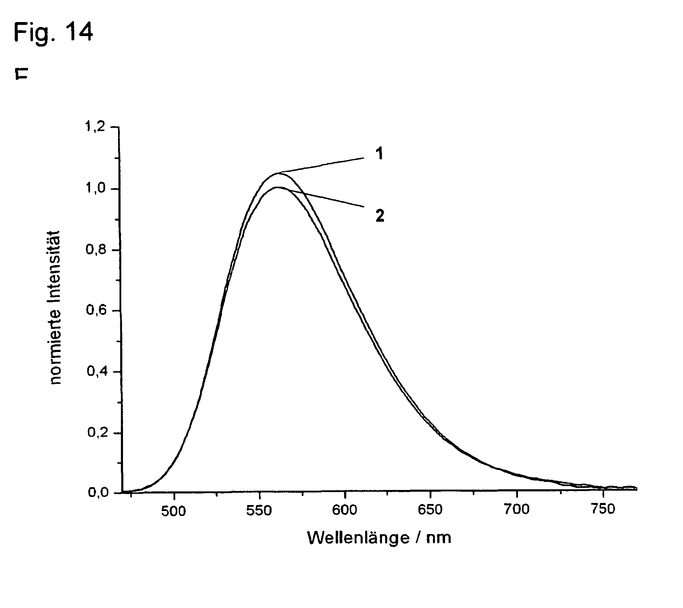

Fig. 14: zeigt einen Vergleich der Emissionsspektren von: 1 = erfindungsgemäß hergestellter Leuchtstoff Ba_{0.345}Sr_{1.6}Eu_{0.055}SiO₄ hergestellt durch Hydrogencarbonat-Fällung; 2 = Leuchtstoff der gleichen Zusammensetzung wie unter 1, hergestellt nach der herkömmlichen Festkörperreaktionsmethode. Der Leuchtstoff 1 weist eine höhere Lichtintensität bzw. Lichtausbeute als Leuchtstoff 2 auf.

## Patentansprüche

1. Verfahren zur Herstellung eines Leuchtstoffes der Formel I
Ba_{w}SrₓCaySiO₄: zEu²⁺ (I)
wobei
w + x +y + z = 2
0,005 < z < 0,5 gilt,
**dadurch gekennzeichnet, dass**
a) mindestens zwei Erdalkalihalogenide sowie ein Europium-haltiger Dotierstoff in Form von Chloriden oder deren Gemische in Wasser gelöst oder suspendiert werden und
b) eine Silicium-haltige Verbindung zugesetzt wird und
c) zu diesem Gemisch ein anorganisches oder organisches Fällungsreagenz zugegeben wird und
d) der entstehende Leuchtstoffprecursor durch thermische Nachbehandlung zum fertigen Leuchtstoff umgewandelt wird.

2. Verfahren nach Anspruch 1, **dadurch gekennzeichnet, dass** vor oder während der thermischen Nachbehandlung ein anorganisches Salz als Flussmittel zugegeben wird.

3. Verfahren nach Anspruch 1 und/oder 2, **dadurch gekennzeichnet, dass** die Silicium-haltige Verbindung eine Silicium-organische Verbindung, vorzugsweise ein Kieselsäureester, ist.

4. Verfahren nach Anspruch 1, **dadurch gekennzeichnet, dass** die Silicium-haltige Verbindung eine anorganische Siliciumverbindung, vorzugsweise feindisperses SiO₂- Sol oder -Gel, ist.

5. Verfahren nach einem oder mehreren der Ansprüche 1 bis 4, **dadurch gekennzeichnet, dass** die thermische Nachbehandlung in reduzierender Formiergasatmosphäre durchgeführt wird.

6. Verfahren nach einem oder mehreren der Ansprüche 1 bis 5, **dadurch gekennzeichnet, dass** die thermische Nachbehandlung in einem thermischen Reaktor wie Drehrohrofen, Kammerofen oder Rohrofen oder in einem Wirbelschichtreaktor erfolgt.

7. Verfahren nach einem oder mehreren der Ansprüche 1 bis6, **dadurch gekennzeichnet, dass** die Oberfläche des Leuchtstoffes zusätzlich mit einer geschlossen Beschichtung aus SiO₂, TiO₂, Al₂O₃, ZnO, ZrO₂ und/oder Y₂O₃ oder Mischoxide daraus versehen wird.

8. Verfahren nach einem oder mehreren der Ansprüche 1 bis6, **dadurch gekennzeichnet, dass** die Oberfläche des Leuchtstoffes mit einer porösen Beschichtung aus SiO₂, TiO₂, Al₂O₃, ZnO, ZrO₂ und/oder Y₂O₃ oder Mischoxide daraus oder aus der Leuchtstoffzusammensetzung versehen wird.

9. Verfahren nach einem oder mehreren der Ansprüche 1 bis8, **dadurch gekennzeichnet, dass** die Oberfläche des Leuchtstoffes zusätzlich mit funktionellen Gruppen versehen wird, welche eine chemische Anbindung an die Umgebung, vorzugsweise aus Epoxy- oder Silikonharz, ermöglichen.

## Claims

1. Process for the preparation of a phosphor of the formula I
Ba_{w}SrₓCa_{y}SiO₄: zEu²⁺ (I)
where
w + x + y + z = 2,
0.005 < z < 0.5,
**characterised in that**
a) at least two alkaline-earth metal halides and a europium-containing dopant in the form of chlorides or mixtures thereof are dissolved or suspended in water, and
b) a silicon-containing compound is added, and
c) an inorganic or organic precipitation reagent is added to this mixture, and
d) the phosphor precursor formed is converted into the finished phosphor by thermal aftertreatment.

2. Process according to Claim 1, **characterised in that** an inorganic salt is added as fluxing agent before or during the thermal aftertreatment.

3. Process according to Claim 1 and/or 2, **characterised in that** the silicon-containing compound is an organosilicon compound, preferably a silicic acid ester.

4. Process according to Claim 1, **characterised in that** the silicon-containing compound is an inorganic silicon compound, preferably a finely disperse SiO₂ sol or gel.

5. Process according to one or more of Claims 1 to 4, **characterised in that** the thermal aftertreatment is carried out in a reducing forming-gas atmosphere.

6. Process according to one or more of Claims 1 to 5, **characterised in that** the thermal aftertreatment is carried out in a thermal reactor, such as a rotary tubular furnace, chamber furnace or tubular furnace, or in a fluidised-bed reactor.

7. Process according to one or more of Claims 1 to 6, **characterised in that** the surface of the phosphor is additionally provided with a closed coating comprising SiO₂, TiO₂, Al₂O₃, ZnO, ZrO₂ and/or Y₂O₃ or mixed oxides thereof.

8. Process according to one or more of Claims 1 to 6, **characterised in that** the surface of the phosphor is provided with a porous coating comprising SiO₂, TiO₂, Al₂O₃, ZnO, ZrO₂ and/or Y₂O₃ or mixed oxides thereof or comprising the phosphor composition.

9. Process according to one or more of Claims 1 to 8, **characterised in that** the surface of the phosphor is additionally provided with functional groups which facilitate chemical bonding to the environment, preferably comprising epoxy or silicone resin.

## Revendications

1. Procédé de préparation d'un luminophore de formule I
Ba_{w}SrₓCa_{y}SiO₄ zEu²⁺ (I)
dans laquelle
w + x + y + z = 2,
0,005 < z < 0.5,
**caractérisé en ce que**
a) au moins deux halogénures de métaux alcalino-terreux et un dopant contenant de l'europium sous la forme de chlorures ou de mélanges de ceux-ci sont solubilisés ou mis en suspension dans de l'eau, et
b) on ajoute un composé contenant du silicium, et
c) un réactif de précipitation inorganique ou organique est ajouté à ce mélange, et
d) le précurseur de luminophore formé est converti en luminophore fini par post-traitement thermique.

2. Procédé selon la revendication 1, **caractérisé en ce que** qu'un sel inorganique est ajouté comme fondant avant ou pendant le post-traitement thermique.

3. Procédé selon la revendication 1 et/ou 2, **caractérisé en ce que** le composé contenant du silicium est un composé d'organo-silicium, préférablement un ester d'acide silicique.

4. Procédé selon la revendication 1, **caractérisé en ce que** le composé contenant du silicium est un composé de silicium inorganique, préférablement un gel ou un sol de SiO₂ finement dispersé.

5. Procédé selon l'une ou plusieurs parmi les revendications 1 à 4, **caractérisé en ce que** le post-traitement thermique est effectué dans une atmosphère de mélange hydrogène-azote réductrice.

6. Procédé selon l'une ou plusieurs parmi les revendications 1 à 5, **caractérisé en ce que** le post-traitement thermique est effectué dans un réacteur thermique, tel qu'un four tubulaire rotatif, un four à chambre ou un four tubulaire, ou dans un réacteur à lit fluidisé.

7. Procédé selon l'une ou plusieurs parmi les revendications 1 à 6, **caractérisé en ce que** la surface du luminophore est pourvue en outre d'un revêtement à structure fermée comprenant SiO₂, TiO₂, Al₂O₃, ZnO, ZrO₂ et/ou Y₂O₃ ou des oxydes mixtes de ceux-ci.

8. Procédé selon l'une ou plusieurs parmi les revendications 1 à 6, **caractérisé en ce que** la surface du luminophore est pourvue d'un revêtement poreux comprenant SiO₂, TiO₂, Al₂O₃, ZnO, ZrO₂ et/ou Y₂O₃ ou des oxydes mixtes de ceux-ci ou comprenant la composition de luminophore.

9. Procédé selon l'une ou plusieurs parmi les revendications 1 à 8, **caractérisé en ce que** la surface du luminophore est pourvue en outre de groupements fonctionnels facilitant une liaison chimique avec l'environnement, préférablement comprenant de la résine époxy ou de silicone.
